# EUROPEAN PATENT APPLICATION

(11) **EP 0 652 568 A1**
(43) Date of publication of application: **10.05.1995**
(21) Application number: 93118208.3
(22) Date of filing: 10.11.1993
(51) Int. Cl.: G11C 29/00

(54) **Memory card tester**

(71) Applicant: International Business Machines Corporation, Armonk, N.Y. 10504 (US)
(72) Inventor: Ruffner, Horst, D-70567 Stuttgart (DE); Klein, Wilfried, Dipl.-Ing. FH., D-71088 Holzgerlingen (DE)
(74) Representative: Jost, Ottokarl, Dipl.-Ing.

(57) **Abstract**

Disclosed is a method and apparatus for testing a memory card (50'). The memory card (50') includes a plurality of storage locations which store data bits and ECC check bits. On the storage controller associated with the memory card (50') under test are provided means (420) for generating a test data pattern and input ECC logic (110) and output ECC logic (160). On reading the test data pattern into the storage locations ECC check bits are generated which are stored in the ECC bit array (140). On reading out the test data pattern, the ECC check bits are used to see whether any error has occurred in the data bits and, if so, this is signalled (ECC_SE; ECC_UCE). The method and apparatus further includes means (370) to step through all the addresses in the memory card (50') under test so that a complete test may be carried out at system speed. On completion of the test, the occurrence of any errors and their location within the memory card (50') may be read from provided registers.

## Description

### Field of the Invention

The invention relates to a memory card comprising data memory with a plurality of storage locations, data input lines connected to a data-in register, data output lines connected to an error detector and a storage controller for controlling the data memory including means for providing a clock signal.

The invention further provides a method for testing a memory card with a data bit array, a check bit array and a keystore (SRAM) array.

### Prior Art

All electronic computers require memory in order to store programs and data. In mainframe computers and large workstations, these memories are located on plugable cards, known as memory cards, which also contain logic to control the memory operations. This logic is known as the storage controller logic. Memory cards which incorporate such logic are known as intelligent memory cards.

All components incorporated on the intelligent memory card are tested before they are mounted on the card. Nevertheless after completion of the manufacturing process, the memory card has to extensively tested before it can be shipped to the customer. These tests are necessary to detect problems caused by component test escapes, tolerance problems, manufacturing problems and possible design problems. Such tests are usually carried out using expensive memory testers which, depending on the performance of the memory card to be tested, may cost up to $2 million. This cost can be explained by the high operation speed and accuracy which has to be provided at the interface of the tester in order to stress the memory card under test.

Current memory testers test memory cards by generating a data pattern for a location in the memory card under test, storing the data pattern into the location and then reading the data pattern out of the location. The stored data pattern is compared with the original data pattern to see whether it has been changed in any way in the memory card. If this is the case, then the presence of an error in the memory card is signalled. This test procedure is repeated for every memory location on the memory card. As a result of the repeated storing, reading and comparison of data patterns, the testing of a high density memory card is very time consuming. For instance testing a 64 MB memory card takes at least a few minutes on a Macrodata MD407 manufacturing tester. Considering the growing capacity of modern memory cards (design work is currently proceeding on a 1 GB card), the time and cost required to test just one memory card will increase tremendously.

A memory testing system is known from US-A-4 980 888 (DEC). The memory tester disclosed in this patent works in a similar manner to that described above. A pseudo-random test pattern is stored in the memory and Error Correcting and Checking (ECC) bits - generated which are also stored in the memory. The test pattern is then read out of the memory and further ECC bits generated. The newly generated ECC bits are then compared with the stored ECC bits for the same test pattern and, on the basis of this comparison, an indication is made whether the memory location is error-free.

The disclosed testing system has the disadvantage that it requires a store and fetch operation for the pseudo-random test pattern and then a data comparison for the ECC bits. In particular the comparison is time-consuming and thus the memory cannot be tested at maximum clock speed. The memory system of US-A-4 980 088 also has the disadvantage that it requires a large amount of additional logic for its operation and a separate test to check the correct functioning of the test logic.

These disadvantages are overcome by a memory card test system according to the invention which has means for receiving a test instruction to initiate a self-test procedure, means for generating a test pattern on receipt of the test instruction, means for providing the generated test pattern to the data-in register of the data memory and means to sense whether the error detector detected an error on the data output lines.

By providing means to sense whether an error detector detected an error on the data output lines, the memory card test system does not require any additional logic to compare the stored and fetched data word or to compare ECC bits. This allows the system to operate at maximum clock speed and to stress the performance of the memory card to the highest amount. Since none of the additional logic is incorporated into time-critical paths, it is not necessary to allow for time delays through the logic when testing the memory card.

In addition, a memory card test system according to the invention requires very little additional logic (approximately 2%) in addition to that already present on the storage controller chip. This is an advantage in that space is saved on the memory card compared to the prior art memory testing system known from US-A-4 980 888 described above. A further advantage is that a test carried out according to the invention also tests the logic required to carry out the storage controller function and hence no separate test is required for this logic. The cost of the test equipment is also comparatively small ($ 3000) which leads to large cost savings compared to the prior art, in particular when the purchase of the tester is amortised over a small number of memory cards.

In an advantageous embodiment of the invention, the memory card test system is provided with means for generating the addresses of the locations of the data memory to be tested. This allows a plurality of locations in the data memory to be tested in one test attempt. Means are provided to detect the last address of the data memory to be tested so that one can step through all of the addresses of the memory card and thus test all locations on the memory card.

In the on-chip memory card test system, the means for receiving a test instruction to initiate a self-test procedure comprises means for receiving and decoding a self test command and means for receiving a test signal to initialise the self-test procedure. During the self test procedure the memory card can be run at or above full system speed. Running the test at a clock rate above the normal system speed allows the card to be stressed and leads to move reliable cards.

The on-chip memory card test system is incorporated into a testing system which further includes a computer running software to control the initialisation of the self-test procedure of the memory card, an adaptor card connected between the memory card and the computer and a programmable power supply connected to the memory card and controlled by the computer.

According to the invention, a method for testing a memory card with a data bit array, a check bit array and a keystore array has the following steps: a first step of initialising a test procedure, a second step of fetching patterns stored in the data bit array and the check bit array of the memory card, a third step of using the patterns fetched from the check bit array to detect whether an error has occurred in the fetched patterns and a fourth step of recording the existence or non-existence of the error.

In an advantageous embodiment of the invention, between the first and second steps the following steps are carried out: a step of generating a test pattern for the test procedure, a step of applying the generated test pattern to the input lines of the array and a step of writing the generated test pattern into one or more storage locations of the memory card.

The test pattern can be generated either by rotating the test pattern generated previously, or using a test pattern generated randomly, or always using the same test pattern, or using the address of the storage location as the test pattern.

In a further embodiment of the invention, the memory card also includes a redundant bit array and the following additional steps are performed: a step of storing in the redundant bit array the same bits as in the check bit array, a step of comparing the contents of one storage location of the redundant bit array with the contents of the corresponding storage location of the check bit array and a step of signalling any differences between the contents of the redundant bit array and the check bit array.

The method and the memory card test system are used for testing memory cards containing dynamic random access memories and static random access memories, in particular keystore memories.

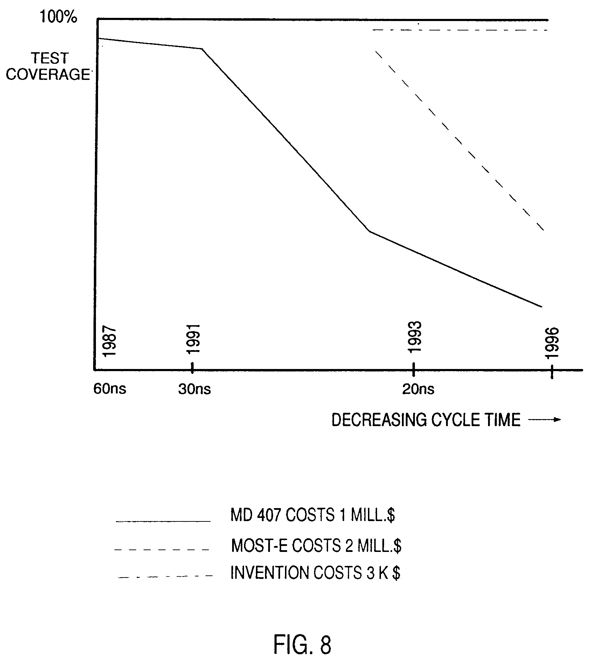

In order to demonstrate the improvement of the memory test system of the current invention compared to prior art test systems, reference is made to Fig. 8 in which the test coverage of two prior art testers is compared with that of the current invention with respect to decreasing clock cycle time, i.e. faster chips. The dates on the graph show the dates at which the clock cycle times were achieved for production models. As is clearly demonstrated by Fig. 8, the test system of the current invention continues to provide almost complete test coverage for the foreseeable future.

### Description of the Figures

- Fig. 1A: shows a prior art memory card
- Fig. 1B: shows the same prior art memory card with an overview of the additional logic required for the invention.
- Fig. 2: shows an overview of the memory card test system of the current invention.
- Fig. 3: shows the array self test logic as required by the current invention.
- Fig. 4: shows an example of the rotation of a data test pattern.
- Fig. 5: shows a flow chart illustrating the steps of the method according to the current invention.
- Fig. 6: shows the values that an 8 bit register within the self test command command decoder may take.
- Fig. 7: shows a flow chart illustrating the steps of a further embodiment of the current invention.
- Fig. 8: shows a graph comparing the memory card test system of the current invention with prior art memory card testers.

### Detailed Description of the Invention

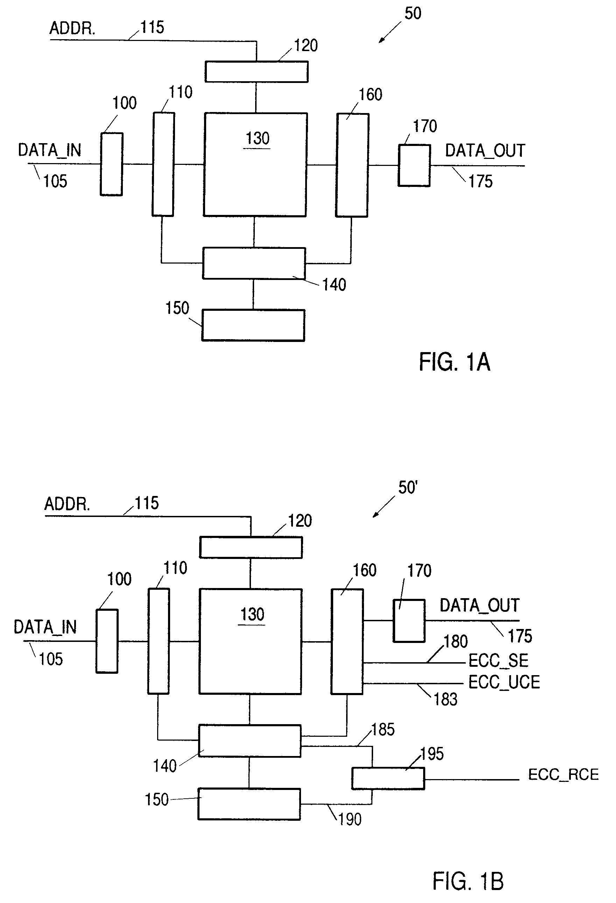

Fig. 1A shows an overview of a prior art memory card 50. It comprises a data-in register 100 connected to data-in lines 105. The data-in register 100 is connected to input error correction code (ECC) logic 110. The inputs of a data bit array 130 and the inputs of an ECC bit array 140 are both connected to the output of the input ECC logic 110. The outputs of the data bit array 130 and the ECC bit array 140 are connected to the input of output ECC logic 160. The output of the output ECC logic 160 is connected to a data-out register 170 which is in turn connected to data-out lines 175. An address decoder 120 is connected to address lines 115 to the word and bit lines of the data bit array 130 and ECC bit array 140. Fig. 1A also shows a redundant bit array 150 whose function is to provide reserve bits in case any of the bits in the data bit array 130 are defective. The logic on the memory card 50 peripheral to the data bit array 130, the ECC bit array 140 and the redundant bit array 150 is collectively known as the storage controller.

The operation of the memory card 50 of Fig. 1A is well-known in the prior art and will be only explained in brief in order to allow a better understanding of the invention. A write operation to store data in the memory card 50 is carried out as follows. Data to be input into the data bit array 130 is passed along the data lines 105 as signal DATA_IN to the data-in register 100 whilst the address data signal ADDR indicating at which address the data is to be stored is passed along the address lines to the address decoder 120. The address decoder 120 decodes the address data and causes the appropriate word and bit lines (not shown) within the data bit array 130 and the ECC bit array 140 to be initialised.

The input ECC logic 110 generates ECC bits from the data in the data-in register 100 and passes to the address decoded in the address decoder 120 the data bits from the data-in register 100 to the data bit array 130 and the generated ECC bits to the ECC bit array 140. The principles of error detection and correction are well known in the prior art. In one design of a memory card 50, the data input is 64 bits in length and 8 ECC bits are generated by the input ECC logic 110.

A read operation from the memory card 50 is carried out as follows. The address in the data bit array 130 from which the data is to be output is passed along the address lines 115 as address signal ADDR to the address decoder 120 where it is decoded and the appropriate bit and word lines in the data bit array 130 and the ECC bit array initialised. The data bit are read out from the data bit array 130 to the ECC logic 160 and the ECC bits generated during the write operation are also passed to the output ECC logic 160. The output ECC logic 160 uses the ECC bits to detect whether there are any errors in the data bits, i.e. whether the values of any of the data bits were altered whilst they were stored in the data bit array 130. If a single error or a package error is detected, then the output ECC logic 160 corrects the value of the erroneous data bit. If multiple errors (except the package error described above) are detected, the output ECC logic 160 can generally not correct such errors and signals this fact to the processor controlling the system. After any necessary correction to the data bits, the output ECC logic 160 passes the data bits to the data-out register 170 from whence the bits are passed to the data out lines 175 as signal DATA_OUT.

Fig. 1B shows the prior art memory card 50 of Fig. 1A modified for the operation of the invention described in the current application. The modified memory card 50' includes all of the elements of Fig. 1A (which have been assigned the same reference signs) as well as two signal lines emanating from the output ECC logic 160. The first line 180 carries a signal ECC_SE indicating that the output ECC logic 160 has detected and corrected a single bit error in the data bit array 130. The second line 183 carries a signal ECC_UCE indicating that the output ECC logic 160 has detected an uncorrectable, multiple bit error in the data bit array 130.

The memory card 50' optionally further includes a line 185 from the ECC bit array 140 and a line 190 from the redundant bit array 150 both leading to a comparer 195. The lines 185 and 190 carry the bits stored in the ECC bit array 140 and the redundant bit array 150 to the comparer 190 where the values of the individual bits are compared as described below. A signal ECC_RCE is generated in the comparer 190.

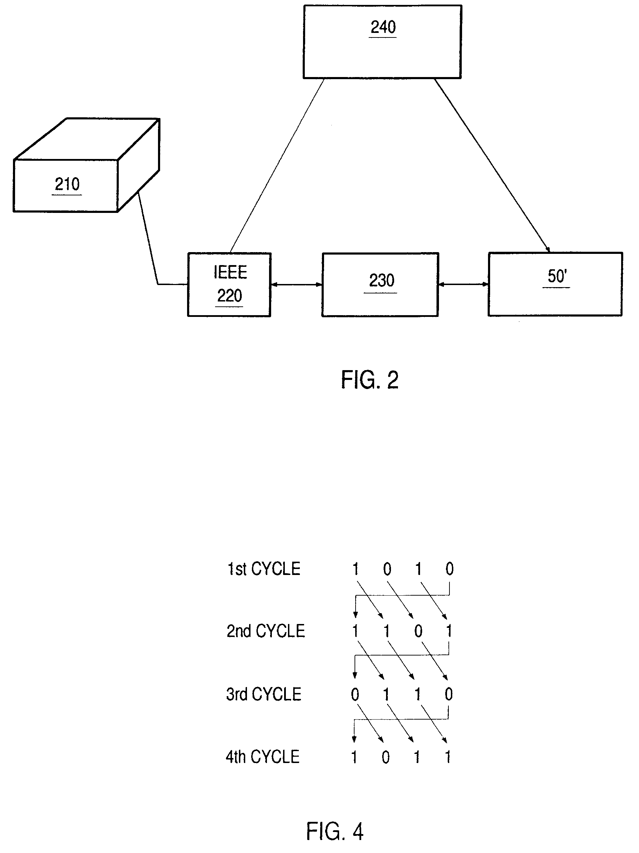

Fig. 2 shows an overview of the system used to test the memory card 50'. A personal computer 210 is provided with an IEEE bus 220. The IEEE bus 220 is connected to an adapter card 230 and a programmable power supply 240. The programmable power supply 240 supplies power to the memory card 50'. The adapter card 230 is connected to the programmable power supply 240 and to the memory card 50'. The adapter card 230 is driven by the commands issued in the personal computer 210 and supplies the commands required by the memory card 50 under test.

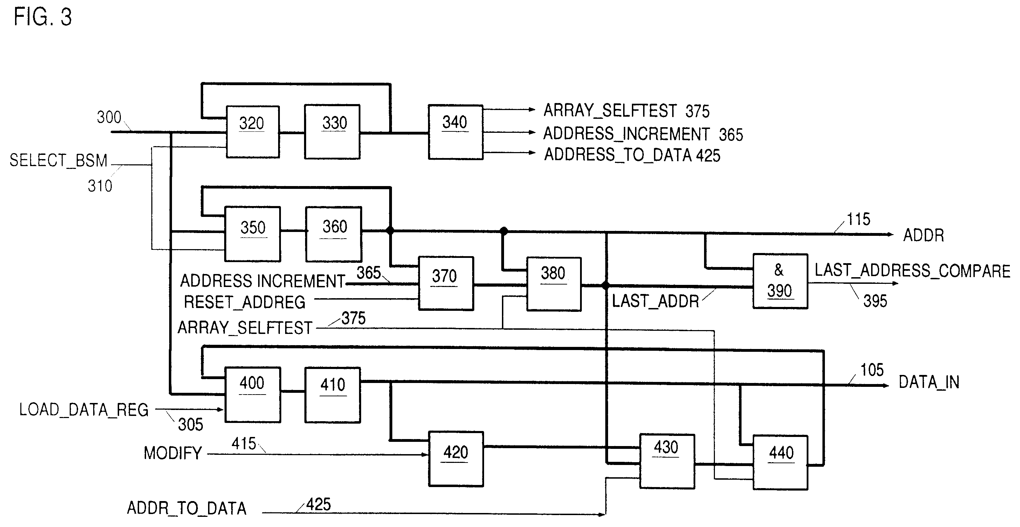

Fig. 3 shows the logic required to implement the testing procedure of the current invention. A memory bus 300 is connected to multiplexers 320, 350 and 400. The memory bus 300 carries a memory command which details the type of memory operation to be carried out and, if appropriate, the address at which the memory operation is to be carried out as well as the data to be written into the data bit array 130. In the prior art system of Fig. 1A, for example, the memory bus 300 would convey the memory commands write and read indicating that data should be stored into or read out of the data bit array 130. The address lines 115 and data-in lines 105 are connected to a memory bus (not shown on Fig. 1A or 1B) which corresponds to the memory bus 300 of Fig. 3.

In the preferred embodiment of the invention, the memory bus 300 is 2 x 8 bytes wide and one line of the data bit array 130 has 64 bytes. Thus four cycles are required to transfer a complete line of data from the memory bus 300 into the data bit array 130 or vice versa.

The multiplexer 320 is connected to a command register 330 which is in turn connected to a self test command decoder 340. The command register 330 stores the memory command passed from the memory bus 300 and passes it to the self test command decoder 340. An output of the command register 330 is connected to an input of the multiplexer 320. This allows the memory command stored in the command register 330 to be recycled. Whether the memory command is recycled or whether a new memory command appearing on the memory bus 300 is passed through the multiplexer 320 to the command register 330 depends on the value of a SELECT_BSM signal on line 310 as will be explained later.

The self test command decoder 340 decodes the memory command which indicates the type of self test to be carried out. It produces signals to control the test of the memory card 50' and its function will be explained in more detail later.

The multiplexer 350 is connected to an address register 360. The address register 360 stores the address appearing on the memory bus 300 after it has passed through the multiplexer 350. The output of the address register 360 is passed as signal ADDR to the address decoder 120 of the memory card 50' along line 115. The signal ADDR indicates the address at which the operation indicated by the memory command is to be carried out.

The output of the address register 360 is also connected to an address adder 370 and a multiplexer 380. The address adder 370 adds to the value of the address stored in the address register 360 a value, address increment 365, and passes the new value to the multiplexer 380. The multiplexer 380 has two inputs, one from the address adder 370 and the other directly from the address register 360. Depending on the value of an ARRAY_SELFTEST signal 375, it passes one of the inputs to its output. From the output, the input is passed back to a multiplexer 350, to an address comparer 390 and to the multiplexer 430.

As will be better understood from the discussion below, the multiplexer 350 can either pass to the address register 360 the address appearing on the memory bus 300 or can recycle (through multiplexer 380) the address stored in the address register 360 or can pass an incremented address. This incremented address has a value equivalent to the address previously stored in the address register 360 incremented by a value address increment 365.

The address lines 115 are also connected to an address comparer 390 which has an input signal, LAST_ADDR, which indicates the maximum value that an address in the memory card under test 50' can take. When the address comparer 390 detects a coincidence between the ADDR signal and the LAST_ADDR signal, then it produces a LAST_ADDR_COMPARE signal on line 395.

The output of the multiplexer 400 is connected to a data-in register 410 which stores the value of the data bits which are to be passed to data bit array 130 of the memory card 50' under test. The data-in register 410 of Fig. 3 essentially corresponds to the data-in register 100 of Fig. 1. The output of the data-in register 410 is connected to the input ECC logic 110 of the memory card 50' under test, to the input of a data modifier 420 and to a multiplexer 440. The output of the data modifier 420 is connected to a multiplexer 430 whose other input is from the output of the multiplexer 380.

The data modifier 420 is able to modify the value of the data which is stored in the data-in register 410. There are several possible modifications which may be carried out and the modification chosen is indicated by the MODIFY signal on line 415.

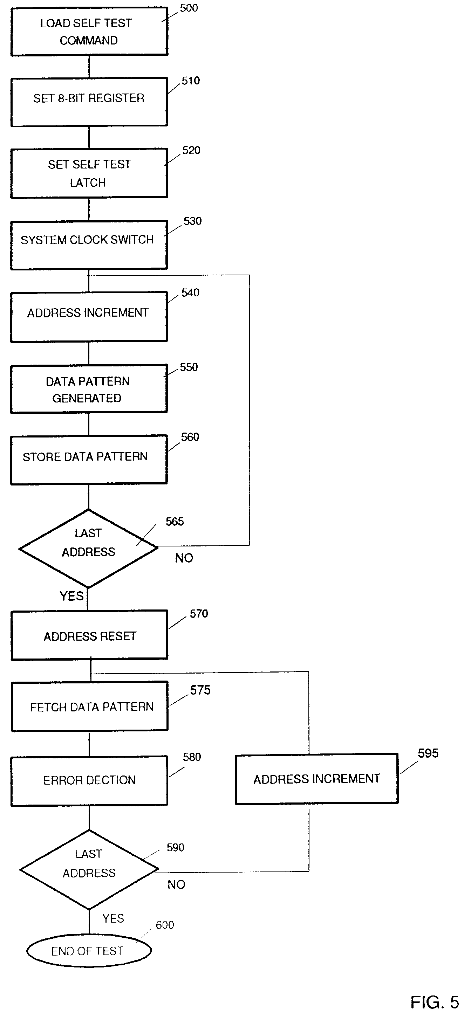

One example of data modification is the rotation of the data. Fig. 4 shows the rotation of a simple, four bit data pattern. In each cycle, the values of the data bits are shifted one place to the right. The rightmost bit (least significant bit) is complemented and placed in the leftmost bit of the data pattern. In the preferred embodiment of the invention, of course, the data patterns are 64 bits in length.

In a further embodiment of the invention, the rightmost bit of the data pattern is not immediately complemented and placed in the leftmost bit position in the subsequent cycle, but is held for one cycle in a holding (65th bit) position and only then complemented and placed in the leftmost bit position of the data pattern. This embodiment has the advantage in that it reduces the occurrence of data pattern repetition.

The data in the data modifier 420 may also be modified in a random way by using a random data pattern generator as known in the prior art or it may fixed, i.e. the same data pattern is read into all of the lines of the data bit array 130.

The multiplexer 430 can either place on its output the output of the multiplexer 380 (i.e. the same value as the address to which the data pattern is to be written) or it can place on its output the modified or unmodified data pattern from the data modifier 420. The value of the data pattern chosen to be output is indicated by the ADDR_TO_DATA signal on line 425.

The multiplexer 440 can either place on its output the value of the output of the multiplexer 430 or the data pattern stored in the data-in register 410. This is determined by the ARRAY_SELFTEST signal on line 375.

The data-in register 410 is loaded from the multiplexer 400 which is controlled by the LOAD_DATA_REG signal on line 305. Thus the data-in register 410 can either be loaded with a new data pattern appearing on the memory bus 300 or it can be loaded through the multiplexer 440 with a modified or unmodified version of the data pattern previously stored in the data-in register 410 or the value of the address at which the data pattern is to be stored.

A description of the operation of the test procedure of the memory card 50' according to the invention is now given with the help of Fig. 5.

In step 500, a self test command is generated in the personal computer 210 and passed through the adapter card 230 to the memory bus 300 of the memory card 50' under test. The self test command is loaded into the command register 330 through the multiplexer 320 and is decoded in the self test command decoder 340. At this stage, the SELECT_BSM signal on line 310 is not active and hence the self test command is passed through the multiplexer.

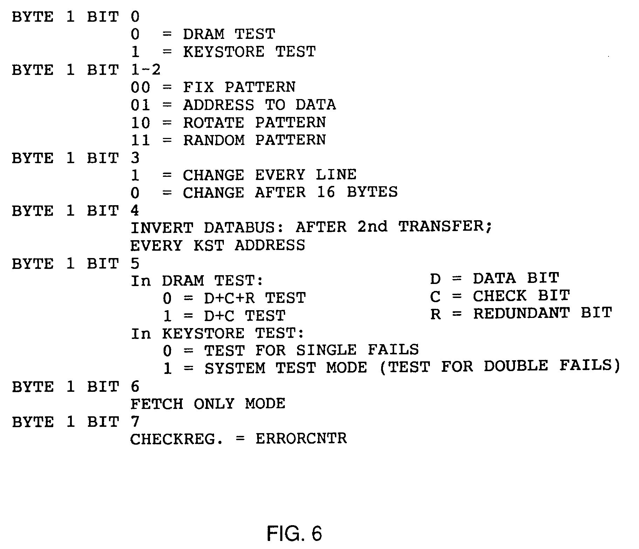

Within the self test command decoder 340 an eight bit register is set (step 510) to indicate which type of testing is to be carried out. Fig. 6 shows the values that the 8 bit register can take. Bit 0 of the register indicates whether a DRAM test or a keystore test is to be carried out. Bits 1 and 2 of the register indicate what type of data pattern is to be used for testing purposes. As described above, the pattern may take one of the following forms:
i) fixed, i.e. have a constant value.
ii) address to data, i.e. the address of the location to which the data is to be written is used as the data pattern. This pattern form is particularly suitable for locating errors in the address lines.
iii) rotation - described above in connection with Fig. 4.
iv) random, i.e. a random pattern generator is used to generate a random pattern.

Bit 3 of the register indicates whether the data pattern is to be changed for every line of the data bit array 130 or whether it is to be changed after every 16 bits. It will be recalled that the memory bus is 16 bits wide. Hence the value of bit 3 indicates whether a new pattern is to be generated after every data pattern transfer to the data bit array 130 or after every fourth data pattern transfer. When carrying out a test of the keystore, the value of bit 3 is irrelevant.

Bit 4 indicates whether, if one is carrying out a DRAM test, after every second transfer, the data pattern on the data-in lines 105 is complemented. If one is carrying out a keystore test, the value of the bit indicates whether the data pattern is to be complemented for every new keystore address tested.

Bit 5 indicates what types of errors are to be indicated. In DRAM tests, there are two possibilities. One may either indicates whether errors are found in the data bits, check bits and redundant bits or alternatively whether errors occur only in the data bits or check bits (i.e. one does not check for possible errors in the redundant bits).

On a typical memory card, there are two keystore memories. The value of bit 5 therefore indicates whether an error should be indicated when both keystores contain an error or whether an error should be signalled when either one of the keystores contains an error.

For the purpose of this explanation, it will be assumed that a DRAM test is being carried out and that bit 5 has been so set that only errors in the check bits and data bits will be detected. This explanation also assumes that the check bits used are ECC bits as are well known in the prior art and have been described in connection with Fig. 1.

Bit 6 indicates whether the self test is operating in fetch only mode. This is useful when one wishes to suppress a write instruction. Suppose, for example, the memory is in systems mode and contains data. By setting the value of this bit, the data already present in the data bit array 130 and ECC array 140 will not be overwritten. The existing data in the arrays will be read out and the test carried out on the basis of this data.

Bit 7 indicates whether the so-called check register is used to count the number of the errors detected on the memory card 50'.

The self test command decoder 340 also sets (step 520) a self test latch (not shown) which indicates that a memory command to initialise a self test operation has been received and that the 8-bit register has been set for operation.

Steps 500 to 520 may be carried out in single-cycle operation or by using a clock signal which is slower than the clock signal used in system operation of the memory card 50'. The initial data and commands required to initiate the self test can be loaded into the logic of the memory card 50' under test through the adapter 230 using relatively slow shift chains.

In step 530, the clock is switched to the normal system time and in step 540, the self-test is begun by switching the SELECT_BSM signal on line 310 high. From this point onwards, the self test is self-executing and stops either when an error in the memory card 50' under test is detected or when all storage locations of the memory card 50' under test have been tested. It should be noted that the SELECT_BSM signal on line 310 only causes the self-testing to commence when the self-test latch has been previously set by a memory command decoded in the self test command decoder 340. After commencement of the self-test operation the self test command decoder 340 produces an ARRAY_SELFTEST signal on line 375 to indicate that the self-test operation has commenced.

As can be seen on Fig. 3, the SELECT_BSM signal line 310 is connected to the multiplexer 320 and the multiplexer 350. When the line 310 goes high, the multiplexers are switched to operation in the self-test mode. The memory command stored in command register 330 is recirculated every cycle through the multiplexer 320 back into the command register 330. Any other memory commands appearing on the memory bus 300 are ignored.

The SELECT_BSM signal on line 310 also switches the multiplexer 350 so that the address appearing at the output of the multiplexer 380 is passed through the multiplexer 350 to the address register 360. Any other address signals appearing on the memory bus 300 are ignored.

During the self test operation, the address stored in the address register 360 is incremented (step 540) in the address adder 370 at the end of every cycle and - as long as the ARRAY_SELFTEST signal on line 375 is high - recirculated through the multiplexers 380 and 350 back to the address register 360.

The value by which the address is incremented is given by the ADDRESS_INCREMENT signal on line 365 which is produced by the self test command decoder 340. The address increment takes the value 4Kbit when a keystore test is being carried out, i.e. the test is page-oriented. If a DRAM test is being carried out, then the address is incremented by 64 bits so that each line of the data bit array 130 and ECC bit array 140 is tested.

The data pattern to be written into the location addressed by the address in the address register 360 is present (step 550) in the data-in register 410. The initial data pattern can be passed on the memory bus 300 through the multiplexer 400. The LOAD_DATA_REGISTER signal on line 305 switches the multiplexer 400 so that it ignores further data patterns appearing on the memory bus 300 and instead takes as its input the output of the multiplexer 440. After the initial data pattern has been loaded into the data-in register 410, it can be modified through the address modifier 420 or a random pattern can be generated as explained above. The data pattern can also be replaced by the address of the location to which the data pattern is to be written. This is indicated by a high ADDR_TO_DATA signal appearing on line 425 which switches the multiplexer 430. The ADDR_TO_DATA signal is generated in the self test command decoder 340 using bits 1 and 2 of the 8 bit register (see Fig. 6).

In step 560 the data pattern generated in step 550 is stored into the data bit array 130 of the memory card 50'. The data pattern is passed through the input ECC logic 110 of Fig. 1B and ECC bits are generated and stored in the ECC bit array 140. As already mentioned above, in the preferred embodiment of the invention, a line of the data bit array 130 has 64 bits and thus the ECC bit array is 8 bits wide. The input ECC logic 110 could be also replaced by other types of error checking mechanisms, e.g. parity checking.

In step 565, a check is made to see whether the last storage address of the memory card 50' under test is reached. This check is carried out by passing the address from the address register 360 to the address comparer 390 whose other input is the value of the last address of the memory card indicated by the LAST_ADDR signal. On detection of a coincidence between the two addresses, the address comparer 390 produces a LAST_ADDRESS_COMPARE signal on line 395 which stops the further storing of data patterns.

The stored data patterns can now be checked for errors. In step 570 the address stored in the address register is reset to the starting address and in step 575 the stored data pattern is retrieved from the data bit array 130 and the generated ECC bits are retrieved from the ECC bit array 140. In the output ECC logic 160, an error correction and detection procedure is carried out to see whether any of the bits stored in the data bit array 130 or the ECC bit array 140 have been changed from the originally stored values. If a change is detected, then the ouput ECC logic 160 produces a signal (not shown) to indicate that there is a fault in the memory card 50' under test. The signal sets an error flag (not shown) to indicate that at least one error in the memory card 50' under test has been encountered.

At this point the self test of the memory card 50' may either be terminated or it may continue. In the latter case and assuming that bit 7 of the 8 bit register (Fig. 6) has been set, the number of errors may be counted in the check register (not shown). If the self test continues, then it is possible also to store the addresses at which the errors were detected in another memory. This is done by reading the address out of the address register 360 when an error is detected.

It should be noted that if bit 6 of the 8 bit register (Fig. 6) is set to indicate fetch only mode, then steps 540, 550 and 560 are not carried out. Instead, the detection of any errors is based upon the data pattern already stored in the memory card 50' on commencement of the self test.

The self test of the memory card 50' is self-executing at system speed - assuming that it is not terminated on occurrence of an error - until the last storage address of the memory card 50' under test is reached (step 590). This check is carried out as described above by passing the address from the address register 360 to the address comparer 390 whose other input is the value of the last address of the memory card indicated by the LAST_ADDR signal. On detection of a coincidence between the two addresses, the address comparer 390 produces a LAST_ADDRESS_COMPARE signal on line 395 which stops (step 600) the further execution of the self test. The self test command decoder 340 sends a signal BUSY_END to the personal computer 210 to indicate that the self test has been completed. If no coincidence is found then in step 595 the address is incremented as described above and the next data pattern fetched.

On completion of the test of the memory card 50', the results are evaluated. If the error flag (not shown) has been set by the output ECC logic 160, then it is known that the memory card 50' is not perfect and appropriate remedial action can be made. In particular, if the addresses of the memory card locations have been stored, then the bits in the redundant bit array 150 can be used to replace the defective bits of the data bit array 130 and the appropriate wiring connections made on the card in order to replace the defective bits.

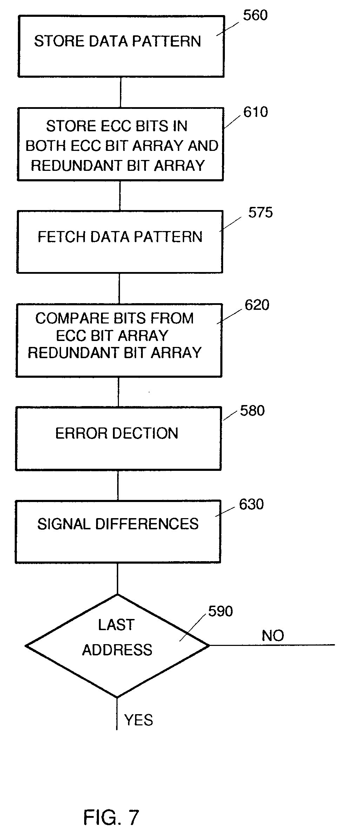

The output ECC logic 160 has furthermore the ability to distinguish between single bit errors and multiple bit errors in a line of the data bit array 130 and ECC bit array 140. If eight ECC bits are used for sixty-four data bits, then single bit errors are correctable, whereas multiple bit errors in the line are generally not correctable. This information can be signalled by the ECC logic 160 and stored in a memory which is accessed by the user or manufacturer of the memory card 50' under test in order to ascertain the seriousness of the error.
Using the same basic testing procedure, a test can also be made of the bits in the redundant bit array 150. Such a test is particularly useful during manufacturing so that one knows which bits of the redundant bit array 150 can be used to replace defective bits of the data bit array 130. This is done by inserting some extra steps between step 560 and step 590 of Fig. 5. The extra steps are shown on Fig. 7.

After storing the data pattern in the data bit array 130 and calculating the ECC bits in the input ECC bit logic 110, the calculated ECC bits are stored both in the ECC bit array 140 and in the redundant bit array 150 (step 610). This, of course, presupposes that the ECC bit array 140 and the redundant bit array 150 are of the same size.

In step 575, the stored data pattern is fetched from the data bit array 130 and the ECC bits are fetched from the ECC bit array 140. As described above, any errors detected by the input ECC logic 160 will be signalled. Supposing that no errors in the data bits or in the ECC bits are found, then in step 620, the bits in the ECC bit array 140 and the bits in the redundant bit array 150 are compared in the comparer 190. If this comparison indicates that the bits are identical, then there is no error in the redundant bit array 150. However, if one or more of the bits are not identical, then there must be an error in the redundant bit array 150 as it is known from calculation carried out in the ECC logic 160 that there are no errors in the ECC bit array 140.

This difference is signalled in step 630 as a signal ECC_RCE from the comparer 190.

The previous examples of the invention have been described for a DRAM memory card 50'. The invention can also be applied to SRAMs. In particular, a so-called keystore may be tested by use of the self test method of the invention. A keystore is a small DRAM which contains a key for access to a page of memory stored in the DRAM. If a processor wishes to obtain access to data stored in a page of the DRAM which is protected (or locked) by a keystore, then the processor must first send the key to the keystore, before access to the DRAM will be granted.

For security reasons, the keystore normally consists of two identical SRAMs of which one is redundant. The self test procedure is initialised by sending the appropriate command to the self test command decoder 340 which sets bit 0 of the eight bit register to the appropriate value to indicate a keystore test and sets bit 5 of the eight bit register to indicate whether a test is to be carried out for single fails, i.e. a location in either one of the memories is defective, or double fails, i.e. the same location in both of the memories is defective. The latter test is particularly suitable for use when the memory card 50' under test is already in the field since it indicates that the keystore is no longer functioning at all.

The self test procedure of the current invention has furthermore the advantage that it can be used in the field, i.e. when the memory card 50' is incorporated in a customer's computer installation. The memory card 50' can be checked every time the power to the computer is switched on or whenever an initial program load occurs or at regular intervals to continually monitor the memory cards 50'. To do this, the personal computer 210 is replaced by the processing unit of the system which executes a diagnostic routine. The processing unit initiates whenever required a predetermined series of memory self tests according to this invention. Only if the tests indicate an error in the memory card 50' is the user of the computer installation informed of the error and advised to call a maintenance engineer.

## Claims

1. Memory card (50') comprising
data memory (130) with a plurality of storage locations, data input lines (105) connected to a data-in register (100) and data output lines (175) connected to an error detector (160),
a storage controller for controlling the data memory (130) with means for providing a clock signal,
characterised in that said storage controller further comprises
means (310, 320, 330, 340, 350) for receiving a test instructions to initiate a self-test procedure,
means (410, 420, 430, 440) for generating a test pattern on receipt of the test instructions,
means (105) for providing the generated test pattern to the data-in register (100) of the data memory (130) and
means (180, 183) to sense whether the error detector (160) detected an error on the data output lines (175).

2. Memory card (50') according to claim 1 further
characterised by
means (360, 370, 380) for generating the addresses of the locations of the data memory (130) to be tested.

3. Memory card (50') according to claim 2 further
characterised by
means (390) to detect the last address of the data memory (130) to be tested.

4. Memory card (50') according to any of the above claims further characterised in that
said means (310, 320, 330, 340, 350) for receiving a test instructions to initiate a self-test procedure comprises
means (320, 350, 340) for receiving and decoding a self test command, and
means (310, 320, 350) for receiving a test signal (SELECT_BSM) to initialise the self-test procedure.

5. Testing System for testing memory cards (50') according to any one of the above claims further including
a computer (210) running software to control the initialisation of the self-test procedure of the memory card (50'),
an adaptor card (230) connected between the memory card (50) and the computer (210), and
a power supply (240) connected to the memory card (50) and controlled by the adapator card (230) and computer (210).

6. Method for testing a memory card (50') with a data bit array (130) and a check bit array (140) comprising
a first step (500, 510, 520) of initialising a test procedure,
a second step (570) of fetching patterns stored in the data bit array (130) and the check bit array (140) of the memory card,
a third step (580) of using the patterns fetched from the check bit array (140) to detect whether an error has occured in the fetched patterns, and
a fourth step (580) of recording the existence or nonexistence of the error.

7. Method of testing a memory card (50') according to claim 6 wherein between the first and second steps the following steps are carried out
a step a) of generating a test pattern for the test procedure,
a step b) (560) of applying the generated test pattern to the input lines (115) of the arrays (130, 140),
a step c) of writing the generated test pattern into one or more storage locations (130, 140) of the arrays (130, 140).

8. Method of testing a memory card (50') according to claim 7 wherein the test pattern of step b) is generated either by
rotating the test pattern generated previously, or
using a test pattern generated randomly, or
always using the same test pattern, or
using the address of the storage location as the test pattern.

9. Method of testing a memory card (50') according to any one of claims 6 to 8 wherein
the check bits stored in the check bit array (140) are generated by a first ECC logic (110), and
the error is detected in a second ECC logic (160).

10. Method of testing a memory card (50') according to any one of claims 6 to 9 wherein the memory card (50) further includes a redundant bit array (150) and the following additional steps are performed
a step i) (610) of storing in the redundant bit array (150) the same bits as in the check bit array (140),
a setp ii) (620) of comparing the contents of one storage location of the redundant bit array (140) with the contents of the corresponding storage location of the check bit array (150), and
a step iii) (630) of signalling any differences between the contents of the redundant bit array (140) and the check bit array (150).

11. Use of the method and apparatus of any one of the above claims for testing memory cards (50) containing dynamic random access memories and static random access memories, in particular keystore memories.
